(19) Europäisches Patentamt
European Patent Office
Office européen des brevets

(11) Veröffentlichungsnummer: **0 293 749 A1**

# (12) EUROPÄISCHE PATENTANMELDUNG

(21) Anmeldenummer: **88108366.1**

(22) Anmeldetag: **26.05.88**

(51) Int. Cl.⁴: **C07C 125/08 , H01L 29/28 , C07D 339/06 , C07D 343/00 , C07D 345/00**

(30) Priorität: **02.06.87 DE 3718365**

(43) Veröffentlichungstag der Anmeldung: **07.12.88 Patentblatt 88/49**

(84) Benannte Vertragsstaaten: **AT BE CH DE FR GB IT LI NL SE**

(71) Anmelder: **BASF Aktiengesellschaft**
**Carl-Bosch-Strasse 38**
**D-6700 Ludwigshafen(DE)**

(72) Erfinder: **Aumueller, Alexander, Dr.**
**An der Marlach 5**
**D-6705 Deidesheim(DE)**
Erfinder: **Huenig, Siegfried, Prof. Dr.**
**Mittlerer Neubergweg 16**
**D-8700 Wuerzburg(DE)**
Erfinder: **Erk, Peter**
**In der Ebene 11**
**D-8708 Gerbrunn(DE)**
Erfinder: **Meixner, Hubert**
**Schillerstrasse 6**
**D-8700 Wuerzburg(DE)**
Erfinder: **Metzenthin, Tobias**
**Leo-Weismantel-Strasse 2016**
**D-8700 Wuerzburg(DE)**

## (54) N,N'-Biscyano-p-benzochinonbisimine, diese enthaltende Charge-Transfer-Komplexe und Radikalionensalze der Biscyano-benzochinonbisimine.

(57) Biscyanimine der allgemeinen Formel

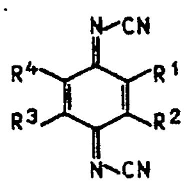

(I),

in der
$R^1$ für 1- oder 2-Propyl, für $C_5$- bis $C_{20}$-Alkyl, $C_3$- bis $C_{20}$-Alkenyl oder Jod und
$R^2$, $R^3$ und $R^4$ unabhängig voneinander für Wasserstoff, Chlor, Brom, Jod, Fluor, Phenyl, $C_1$- bis $C_{20}$-Alkyl, $C_3$- bis $C_{20}$-Alkenyl oder $C_1$- bis $C_8$-Alkoxy stehen.
Die Biscyanimine (I) geben mit Fulvalenverbindungen der Formel



Xerox Copy Centre

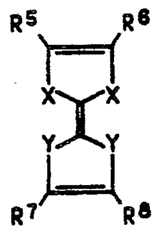

(II),

wobei das Verhältnis von (I) : (II) = 1:1, 2:1, 3:2, 1:2 oder 2:3 Mol beträgt Charge-Transfer-Komplexe die elektrisch leitend sind.

Weiterhin geben die Biscyanimine (I) elektrisch leitende Radikalionensalze der Formel

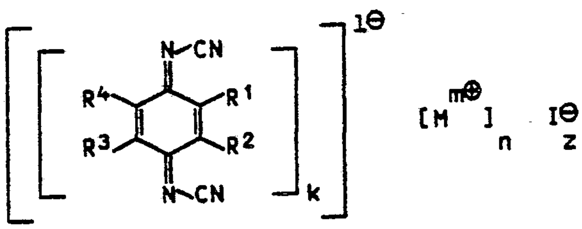

(III),

in der

$R^1$, $R^2$ und $R^4$ die oben angegebene Bedeutung haben und

$M^{m\oplus}$ für ein m-wertiges Alkalimetall-, Erdalkalimetall-, Übergangsmetall-, Ammonium- oder Phosphoniumion,

k für 1 bis 3,

l für 1 bis 3,

m für 1 oder 2,

n für 1 bis 3 und

z für 0 bis 2 stehen, wobei k, l, n und z auch gebrochene Zahlen sein können und die Summe $(l+z)$ = $n \cdot m$ ist.

Die aus (I) herstellbaren Charge-Transfer-Komplexe und die Radikalionensalze (III) eignen sich z.B. für elektrische Halb- und Photoleiter, als Elektroden- und Speichermaterial in elektrische Batterien, für Brennstoffzellen und zur antistatischen Ausrüstung von Kunststoffen.

# N,N'-Biscyano-p-benzochinonbisimine, diese enthaltende Charge-Transfer-Komplexe und Radikalionensalze der Biscyano-benzochinonbisimine

N,N'-Biscyano-p-benzochinonbisimine, deren Herstellung und von diesen Biscyanoiminen abgeleitete Charge-Transfer-Kompolexe mit Tetrathia/Tetraselenafulvalenverbindungen sind aus der DE-A 34 37 814 bekannt.

Radikalionensalze aus Tetracyanchinodimethanen und Kupfer oder Silber sind bekannt [Appl. Phys. Lett. 34, 405 (1979), J. Amer. chem. Soc. 102, 3659 (1980), Chem. Skripta 17, 219 (1981)].

Radikalionensalze auf der Basis von N,N'-Biscyano-benzochinonbisiminen werden in der EP-A 206 266 beschrieben.

Aufgabe der Erfindung war es, weitere N,N'-Biscyano-p-benzochinonbisimine bereitzustellen, deren Charge-Transfer-Komplexe oder Radikalionensalze überlegene Eigenschaften aufweisen.

Gegenstand der Erfindung sind Biscyanimine der allgemeinen Formel

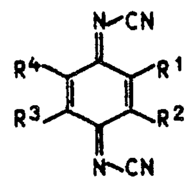

(I),

in der

$R^1$ für 1- oder 2-Propyl, für $C_5$- bis $C_{20}$-Alkyl, $C_3$- bis $C_{20}$-Alkenyl oder Jod und

$R^2$, $R^3$ und $R^4$ unabhängig voneinander für Wasserstoff, Chlor, Brom, Jod, Fluor, Phenyl, $C_1$- bis $C_{20}$-Alkyl, $C_3$- bis $C_{20}$-Alkenyl oder $C_1$- bis $C_8$-Alkoxy stehen.

Gegenstand der Erfindung sind außerdem Charge-Transfer-Komplexe aus Biscyaniminen der allgemeinen Formel

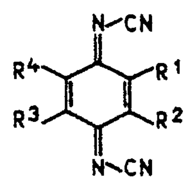

(I)

und Fulvalenverbindungen der allgemeinen Formel

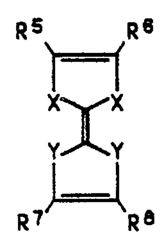

(II),

wobei das Verhältnis von (I) : (II) = 1:1, 2:1, 3:2, 1:2 oder 2:3 Mol beträgt und in den Formeln

$R^1$ für 1- oder 2-Propyl, für $C_5$- bis $C_{20}$-Alkyl, $C_3$- bis $C_{20}$-Alkenyl oder Jod und

$R^2$, $R^3$ und $R^4$ unabhängig voneinander für Wasserstoff, Chlor, Brom, Jod, Fluor, Phenyl, $C_1$- bis $C_{20}$-Alkyl, $C_3$- bis $C_{20}$-Alkenyl oder $C_1$- bis $C_8$-Alkoxy,

$R^5$, $R^6$, $R^7$ und $R^8$ unabhängig voneinander für Wasserstoff, Methyl oder Ethyl, oder $R^5$ und $R^6$ oder $R^7$ und $R^8$ oder $R^5$ und $R^6$ und $R^7$ und $R^8$ zusammen jeweils für einen Rest der Formel

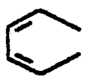 , 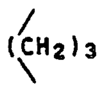 , 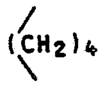 , 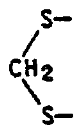 , 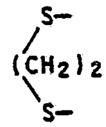 oder

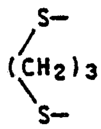 und

X und Y unabhängig voneinander für S oder Se stehen.

Außerdem sind die sich von den Biscyanobenzochinonbisiminen (I) ableitenden Radikalionensalze (III) Gegenstand der vorliegenden Erfindung. Dementsprechend betrifft die Erfindung auch Radikalionensalze der allgemeinen Formel

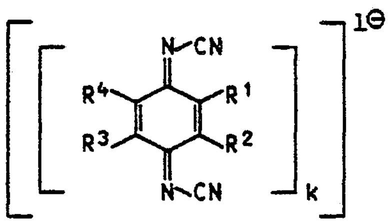 $[M^{m\oplus}]_n \; I_z^{\ominus}$ (III),

in der

$R^1$ für 1- oder 2-Propyl, für $C_5$- bis $C_{20}$-Alkyl, $C_3$- bis $C_{20}$-Alkenyl oder Jod und

$R^2$, $R^3$ und $R^4$ unabhängig voneinander für Wasserstoff, Chlor, Brom, Jod, Fluor, Phenyl, $C_1$- bis $C_{20}$-Alkyl, $C_3$- bis $C_{20}$-Alkenyl oder $C_1$-bis $C_8$-Alkoxy,

$M^{m\oplus}$ für ein m-wertiges Alkalimetall-, Erdalkalimetall-, Übergangsmetall-, Ammonium- oder Phosphoniumion,

k für 1 bis 3,

l für 1 bis 3,

m für 1 oder 2,

n für 1 bis 3 und

z für 0 bis 2 stehen, wobei k, l, n und z auch gebrochene Zahlen sein können und die Summe $(l+z) = n \bullet m$ ist.

Die aus den Biscyanchinondiminen (I) erhaltenen Charge-Transfer-Komplexe aus (I) und (II) und die Radikalionensalze (III) sind den Charge-Transfer-Komplexen des Standes der Technik und/oder den nächstliegenden Radikalionensalzen des Standes der Technik in den anwendungstechnischen Eigenschaften überlegen.

Bei den Biscyaniminen (I) kommen für $R^1$ außer den bestimmt genannten im einzelnen in Betracht:

als $C_5$- bis $C_{20}$-Alkyl, z.B. n-Pentyl, Pentyl-2 und -3, 3-Methyl-butyl-1 und -2, n-Hexyl, Isohexyl, Heptyl, Octyl, 2-Ethylhexyl, Nonyl, Decyl, Dodecyl, Tridecyl, Tetradecyl, Pentadecyl, Hexadecyl, Octadeyl und Eicosyl;

als $C_3$- bis $C_{20}$-Alkenyl z.B. Allyl, But-2-en-yl-1 und Oleyl.

Für $R^2$, $R^3$ und $R^4$ sind außer Wasserstoff, Chlor, Brom, Jod, Fluor und Phenyl im einzelnen zu nennen: $C_1$- bis $C_{20}$-Alkyl wie Methyl, Ethyl, n- und i-Propyl, Butyl, i-Butyl, tert.-Butyl und die für $R^1$ genannten Alkylreste; $C_3$- bis $C_{20}$-Alkenyl die für $R^1$ genannten Alkenylreste;

$C_1$- bis $C_8$-Alkoxy wie Methoxy, Ethoxy, n- und i-Propoxy, n- und i-Butoxy, Pentoxy, Hexoxy, Heptoxy, Octoxy and 2-Ethylhexoxy.

Bevorzugt sind Biscyanimine (I), in denen $R^2$ und $R^4$ oder $R^3$ und $R^4$ oder $R^2$, $R^3$ und $R^4$ Wasserstoff sind. Besonders bevorzugt sind Verbindungen der Formel (I), in der $R^2$ und $R^4$ Wasserstoff sind.

Weiterhin sind solche Biscyanimine (I) besonders bevorzugt, bei denen $R^1$ für Iod steht.

Die Herstellung der Biscyanimine (I) erfolgt analog den in der DE-A 34 37 814 beschriebenen Verfahren, vorzugsweise nach dem dort unter b) beschriebenen Verfahren durch Umsetzen von Chinonen der Formel (IV) mit Bistrimethylsilylcarbodiimid (V) in Gegenwart von Katalysatoren

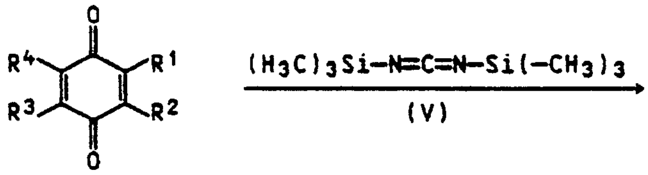


(I)

(IV)

Zur Umsetzung von (IV) mit (V) werden mindestens 2 Mol (V) je Mol (IV) angewendet. Vorteilhafterweise erfolgt die Umsetzung in inerten organischen Lösungsmitteln, z.B. Dichlormethan, Chloroform, 1,1,1-Trichlorethan, 1,2-Dichlorethan oder Acetonitril und in Gegenwart von Katalysatoren. Als Katalysatoren kommen z.B. in Betracht: Caesiumfluorid, Kaliumcyanid-Kronenether wie 18-Krone-6, oder Titantetrachlorid, von denen Titantetrachlorid bevorzugt ist.

Die Herstellung der erforderlichen p-Benzochinone erfolgte nach J.Chem. Soc. 1942, S. 659 ff.

Die Oxidation der Hydrochinonverbindung erfolgt vorteilhafterweise mit Chromsäure/Schwefelsäure in Aceton/Ether-Gemischen (Dauer 1-2 h, Ausbeuten ≦ 90 % d.Th.).

Das zur Herstellung von 2-Brom-5-dodecyl-p-benzochinon erforderliche Hydrochinon wurde durch Bromierung von 2-Dodecyl-1,4-dimethoxybenzol in Anlehnung an Chem. Pharm. Bull. 20, (1972) 1968 hergestellt. 2-Hexyl-p-benzochinon ist in J. Amer. Chem. Soc. 87, S. 4585 (1965) beschrieben.

Als zweite Komponente für die Charge-Transfer-Komplexe aus (I) und (II) sind Fulvalenverbindungen der Formel (II) bevorzugt, in der $R^5 = R^6 = R^7 = R^8$ = Wasserstoff oder Methyl oder $R^5$ = Methyl, $R^6$ = Wasserstoff und einer der Reste $R^7$ oder $R^8$ Wasserstoff und der andere der Reste $R^7/R^8$ Methyl bedeutet.

Hervorzuheben sind ferner Fulvalenderivate (II), bei denen $R^5$ und $R^6$ und $R^7$ und $R^8$ zusammen jeweils einen Rest der Formel

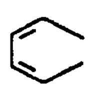 , 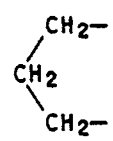 , 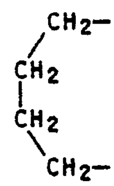 oder 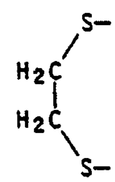

bedeuten.

Die Fulvalenderivate (II) sind bekannt (Synthesis 1976, Seite 489 ff).

Bevorzugt sind solche Fulvalenderivate (II), bei denen X und Y jeweils für S stehen.

In den Charge-Transfer-Komplexen kann das Verhältnis von (I) : (II) 1:1, 2:1, 3:2, 1:2 oder auch 2:3 Mol betragen.

Zur Herstellung der erfindungsgemäßen Charge-Transfer-Komplexe werden Biscyanimine der Formel (I) mit Fulvalenen der Formel (II) im angegebenen Molverhältnis in einem Lösungsmittel, gegebenenfalls in der Wärme, umgesetzt. Als Lösungsmittel kommen beispielsweise Dichlormethan, Chloroform, 1,1,1-Trichlorethan, Acetonitril, Benzol, Toluol, Chlorbenzol oder Dichlorbenzol in Frage.

Die Charge-Transfer-Komplexe werden üblicherweise durch Absaugen isoliert.

Für $R^1$, $R^2$, $R^3$ und $R^4$ kommen die für (I) genannten Substituenten in Betracht.

Von den Radikalionensalzen (III) sind solche bevorzugt, bei denen $R^2$ und $R^4$ oder $R^3$ und $R^4$ oder $R^2$, $R^3$ und $R^4$ Wasserstoff sind.

Besonders bevorzugt sind solche Salze (III), in denen $R^2$ und $R^4$ für Wasserstoff stehen. Weiterhin sind solche (III) bevorzugt, in denen $R^1$ Iod bedeutet.

Ganz besonders bevorzugt sind Radikalionensalze der Formel (III), in der $R^2 = R^4$ = Wasserstoff und $z = 0$ sind.

Als $M^{m\oplus}$ kommen Metallionen von Metallen, deren Redoxpotential ≦ dem des Silbers ist, außerdem Ammonium und Phosphonium in Betracht.

Als Alkalimetallionen kommen die von Lithium, Natrium, Kalium, Rubidium und Caesium, als Erdalkalimetalle die von Calcium, Strontium und Barium, von den Übergangsmetallen, z.B. die des Chroms, Mangans, Eisens, Cobalts, Nickels, Kupfers, Zinks, Silbers, Cadmiums und Quecksilbers sowie des Zinns, Bleis und Thalliums in Betracht.

Als Ammonium sind z.B. zu nennen: $C_1$- bis $C_4$-Tetraalkylammonium, Tetraphenyl-$C_1$- bis $C_3$-alkylam-

monium, Phenyl-$C_1$- bis $C_3$-alkyl-tris-$C_1$- bis $C_4$-alkylammonium, $C_1$- bis $C_4$-Alkyl-pyridinium, N-Phenyl-$C_1$-bis $C_3$-Alkylpyridinium, Chinolinium, N-$C_1$- bis $C_4$-Alkylchinolinium, N-Phenyl-$C_1$- bis $C_3$-alkylchinolinium sowie die entsprechenden Isochinoliniumverbindungen.

Als Phosphoniumionen kommen vor allem solche in Betracht, die sich von den Triphenylverbindungen ableiten.

Als $M^{m\oplus}$ sind im einzelnen zu nennen: $Li^{\oplus}$, $Na^{\oplus}$, $K^{\oplus}$, $Rb^{\oplus}$, $Cs^{\oplus}$, $Mg^{2\oplus}$, $Ca^{2\oplus}$, $Ba^{2\oplus}$, $Sr^{2\oplus}$, $Cr^{3\oplus}$, $Mn^{2\oplus}$, $Fe^{2\oplus}$, $Fe^{3\oplus}$, $Co^{2\oplus}$, $Ni^{2\oplus}$, $Cu^{\oplus}$, $Cu^{2\oplus}$, $Zn^{2\oplus}$, $Ag^{\oplus}$, $Cd^{2\oplus}$, $Hg^{2\oplus}$, $Sn^{2\oplus}$, $Pb^{2\oplus}$, $Pb^{4\oplus}$, $Tl^{\oplus}$, $Tl^{3\oplus}$, Triphenylmethylphosphonium, Tetramethylammonium, Tetraethylammonium, Tetrapropylammonium, Tetrabutylammonium, Tetrabenzylammonium, Tetra(2-phenylethyl)-ammonium, Trimethylbenzylammonium, Triethylbenzylammonium, Pyridinium, N-Methyl- und N-Ethylpyridinium, N-Methyl-2-methylpyridinium, N-Methyl-3-methylpyridinium, N-Methyl-4-methylpyridinium, N-Benzylpyridinium, Chinolinium, N-Methyl-, N-Ethyl- und N-Benzylchinolinium.

Als $M^{m\oplus}$ sind bevorzugt die des Lithiums-, Natriums-, Kaliums-, Rubidiums-, Caesiums, Kupfers-I- und Silbers-I, Tetramethylammonium, Tetraethylammonium, Tetrabenzylammonium, Trimethylbenzylammonium, Triethylbenzylammonium, Chinolinium, Pyridinium, N-Methylpyridinium, N-Methylchinolinium und N-Ethylchinolinium. Von diesen sind Kupfer-I, Silber-I, Pyridinium, N-Methylpyridinium, Chinolinium und N-Methylchinolinium besonders bevorzugt.

Die erfindungsgemäßen Salze (III) (Komplexe) weisen im kristallinen Zustand elektrische Leitfähigkeit auf. Eine Reihe der Verbindungen (I) ist thermostabil bei Temperaturen um und über 300 °C. Dementsprechend sind die neuen Komplexe zur Verwendung als elektrische Halb- und Photoleiter geeignet, z.B. zur antistatischen Ausrüstung von Kunststoffen, als Elektroden- oder Speichermaterial in elektrischen Batterien, zur Herstellung von Solarzellen, in Brennstoffzellen, zur Umwandlung von Strahlung und zur Herstellung elektronischer Bauteile. Mikrokristalline Filme aus den erfindungsgemäßen Radikalionensalze können zur Herstellung bistabiler elektrischer Schaltelemente verwendet werden.

Die erfindungsgemäßen Radikalionensalze (III) können nach verschiedenen Verfahrensvarianten hergestellt werden. Ein Weg ist die Umsetzung von N,N′-Dicyanchinondiimen der Formel (I)

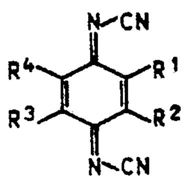

(I),

in der $R^1$, $R^2$, $R^3$ und $R^4$ die oben genannte Bedeutung haben, mit Halogeniden, vorzugsweise Iodiden der oben genannten Kationen $M^{m\oplus}$ im Molverhältnis 3:1 bis 1:3 in einem Lösungsmittel, gegebenenfalls in der Wärme. Als Lösungsmittel kommen beispielsweise Dichlormethan, Chloroform, 1,1,1-Trichlorethan, Acetonitril, Benzol, Toluol, Chlorbenzol oder Dichlorbenzol in Frage. Die Radikalionensalze werden in üblicher Weise durch Absaugen isoliert.

Die erfindungsgemäßen Radikalionensalze (III) können weiterhin durch Elektrolyse einer Lösung, die ein N,N′-Dicyanchinodiimin der Formel (I) und ein Salz der oben genannten Kationen ($M^{m\oplus}$) in einem der oben genannten Lösungsmittel enthält, gegebenenfalls bei niedriger Temperatur, hergestellt werden. Die Radikalionensalze werden auch hier in üblicher Weise durch Absaugen isoliert.

Weitere Verfahren, nach denen die Radikalionensalze (III) hergestellt werden können, sind in der EP-A 206 266 beschrieben.

Die Herstellung von mikrokristallinen Filmen die aus den erfindungsgemäßen Radikalionensalzen bestehen, kann in an sich bekannter Weise durch Eintauchen eines metallischen Körpers in eine Lösung eines N,N′-Dicyanchinonimins in einer der oben genannten Lösungsmittel, vorzugsweise bei erhöhter Temperatur erfolgen.

Die Erfindung soll durch die folgenden Beispiele weiter erläutert werden. Prozentangaben bei den Ausbeuten stehen für Prozent der theoretischen Ausbeute. Die angegebenen Leitfähigkeiten wurden an Pulverpreßlingen oder an Einkristallen bestimmt.

I. N,N′-Biscyano-p-benzochinonbisimine (I)

Beispiel 1

2-Dodecyl-N,N-dicyan-1,4-benzochinondiimin (I.1)

Die Reaktion wird in einem ausgeheizten Kolben unter trockener Stickstoffatmosphäre durchgeführt. Man legt 1,90 g (10 mmol) $TiCl_4$ in 10 ml absolut wasserfreien Dichlormethan vor und tropft bei 0° C 1,86 g (10 mmol) Bistrimethylsilylcarbodiimid zu. Anschließend wird eine Lösung von 553 mg (2 mmol) 2-Dodecyl-p-benzochinon in 6 ml Dichlormethan bei 0° C langsam zugetropft. Nach dem Zutropfen rührt man 24 h bei Raumtemperatur.

Die Reaktionsmischung wird auf Eis gegossen, mit Dichlormethan extrahiert, über $MgSO_4$ getrocknet und nach der Filtration eingeengt. Die konzentrierte Dichlormethanlösung wird über Kieselgel (0,063-0,2 mm) filtriert, das klare Eluat mit 3 ml Methylcyclohexan versetzt und eingeengt bis Kristallisation eintritt. Filtration und Trocknung im Vakuum (20 Torr). Auswaage: 380 mg (I.1), entsprechend 59 %, Schmp. 97-98° C.

IR (KBr) 2160 $cm^{-1}$

Analyse $C_{20}H_{28}N_4$ (324,5)

ber. C 74,03 H 8,70 N 17,27 %

gef. 74,35 8,97 17,14 %

Beispiele 2 bis 8

Analog den Angaben in Beispiel 1 wurden die in der Tabelle 1 angegebenen Verbindungen der Formel (I) hergestellt

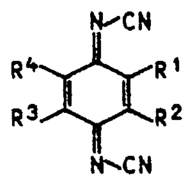

| Beispiel | $R^4$ = H<br>$R^1$ | $R^2$ | $R^3$ | Schmp. [°C] | Ausbeute [%] d.Th. | IR (KBr) [$cm^{-1}$] |
|---|---|---|---|---|---|---|
| 2 | i-$C_3H_7$ | H | $CH_3$ | 120 | 74 | 2170 |
| 3 | Allyl | Allyl | H | 69 | 14 | 2170 |
| 4 | Allyl | H | Allyl | 90 | 60 | 2175 |
| 5 | J | H | $CH_3$ | 162 | 79 | 2170 |
| 6 | J | H | H | 121 | 45 | 2175 |
| 7 | J | H | Br | 226 | 72 | 2170 |
| 8 | J | H | J | 233 | 42 | 2140 |

Beispiel 9

N,N′-Dicyan-2-octadecyl-1,4-chinondiimin (I.2)

8,10 g (43,0 mmol) Titantetrachlorid werden in 50 ml absolut wasserfreiem Dichlormethan vorgelegt und bei 0 °C 7,95 g (42,7 mmol) Bistrimethylsilylcarbodiimid langsam zugetropft. Anschließend werden in die erhaltene Mischung dann 3,08 g (8,54 mmol) 2-Octadecyl-1,4-benzochinon in 50 ml Dichlormethan langsam zugegeben und rührt 48 h bei Raumtemperatur. Nach dem Dünnschichtchromatogramm (Kieselgel; Laufmittel: Dichlormethan/Petrolether 4:1 Vol) ist die Reaktion dann beendet. Der Reaktionsansatz wird auf Eiswasser gegossen, mit Dichlormethan extrahiert und der Extrakt über Magnesiumsulfat getrocknet. Der eingeengte Extrakt wird über Kieselgel filtriert und das Eluat mit 5 ml Methylcyclohexan versetzt. Aus dem Gemisch wird das Dichlormethan bis zur beginnenden Kristallisation abdestilliert. Nach dem Umkristallisieren aus Methylcyclohexan (26 ml für 791 mg Rohprodukt) erhält man 662 mg (20 % d.Th.) (I.2) als feinen gelben Niederschlag.
Schmp. 102 °C
Analyse $C_{26}H_{40}N_4$ (409)
Ber. C 76,42 H, 9,87 N 13,71 %
Gef. C 76,05 H 9,93 N 13,68 %
Spektren:
IR (KBr) : $\nu$ = 3050 $cm^{-1}$ (CH), 2920 (CH), 2850 (CH), 2175 (C≡N), 1575 (C=C), 1545 (C=N).
UV ($CH_3CN$): $\lambda_{max}$ (lg $\epsilon$) = 334 nm (4,44).

Beispiel 10

N,N′-Dicyan-2-brom-5-octadecyl-1,4-chinondiimin (I.3)

Analog Beispiel 9 tropft man bei 0 °C 5,31 g (28,5 mmol) Bistrimethylsilylcarbodiimid langsam zu 5,50 g (29,0 mmol) Titantetrachlorid in 20 ml absolutem Dichlormethan. Anschließend wird eine Lösung von 2,51 g (5,70 mmol) 2-Brom-5-octadecyl-1,4-benzochinon in 40 ml Dichlormethan innerhalb von 45 min zugegeben. Danach läßt man auf Raumtemperatur erwärmen und rührt noch weitere 48 h. Die Aufarbeitung des Reaktionsgemisches erfolgt wie bei Beispiel 9. Das Kieselgel-Eluat wird bis zur beginnenden Kristallisation eingeengt und man setzt portionsweise insgesamt 400 ml Petrolether zu und vervollständigt die Fällung bei -25 °C.
Ausbeute: 1,52 g (55 % d.Th.) (I.3) als analysenreinen orangenen Farbstoff
Schmp. 125 °C (Zers.)
Analyse $C_{26}H_{39}BrN_4$ (488)
Ber. C 64,05 H 8,06 N 11,49 %
Gef. C 63,76 H 8,06 N 11,57 %
Spektren:
IR (KBr): $\nu$ = 3040 $cm^{-1}$ (CH), 2910 (CH), 2840 (CH), 2165 (C≡N), 1560 (C=C), 1545 (C=N).
UV ($CH_2Cl_2$: $\lambda_{max}$ (lg $\epsilon$) = 355 nm (4,51), 370 (4,41) sh.

Beispiel 11

N,N′-Dicyan-2-dodecyl-1,4-chinondiimin (I.4)

Es wird analog Beispiel 9 verfahren und legt 1,90 g (10,0 mol) Titantetrachlorid in 10 ml absolutem Dichlormethan vor und tropft bei 0 °C 1,86 g (10,0 mmol) Bistrimethylsilylcarbodiimid innerhalb von 30 Minuten zu. Anschließend wird eine Lösung von 553 mg (2,00 mmol) 2-Dodecyl-1,4-benzochinon in 6 ml Dichlormethan innerhalb von 30 Minuten zugegeben. Die Reaktionsmischung wird 24 h bei Raumtemperatur gerührt und wie bei Beispiel 9 aufgearbeitet.
Ausbeute: 380 mg (59 % d. Th.) (I.4) in Form eines feinen gelben Niederschlags.
Schmp.: 98 °C.
Analyse $C_{20}H_{28}N_4$ (325)

Ber. C 74,03 H 8,70 N 17,27 %
Gef. C 74,35 H 8,97 N 17,14 %
Spektren:
IR (KBr): $\nu$ = 3045 $cm^{-1}$ (CH), 2910 (CH), 2840 (CH), 2160 (C≡N), 1570 (C=C), 1550 (C=N).
UV ($CH_3CN$): $\lambda_{max}$ (lg $\epsilon$) = 334 nm (4,44).

Beispiel 12

N,N′-Dicyan-2-dodecyl-5-methyl-1,4-chinondiimin (I.5)

Man verfährt analog Beispiel 9 und tropft bei 0°C 10,4 g (56,0 mmol) Bistrimethylsilylcarbodiimid innerhalb von 30 Minuten zu 11,0 g (58,0 mmol) Titantetrachlorid in absolutem Dichlormethan. Danach wird eine Lösung von 2,32 g (8,00 mmol) 2-Dodecyl-5-methyl-1,4-benzochinon in 27 ml Dichlormethan langsam zugegeben. Nach langsamen Erwärmen auf Raumtemperatur rührt man noch 48 h und isoliert wie im Beispiel 9.
Ausbeute: 2,06 g (76 % d.Th.) (I.5) in Form orange-gelber Nadeln, die sich bei 114°C zersetzen.
Analyse $C_{21}H_{30}N_4$ (339)
Ber. C 74,51 H 8,93 N 16,55 %
Gef. C 74,68 H 9,20 N 16,48 %
Spektren:
IR (KBr): $\delta$ = 3045 $cm^{-1}$ (CH), 2918 (CH), 2845 (CH), 2185, 2172 (C≡N), 1585 (C=C), 1545 (C=N).
UV ($CH_3CN$): $\lambda_{max}$ (lg $\epsilon$) = 344 nm (4,41).

Beispiel 13

2-Brom-N,N′-dicyan-5-dodecyl-1,4-chinondiimin (I.6)

Es wird wie in Beispiel 9 verfahren und bei 0°C 10,6 g (57,0 mmol) Bistrimethylsilylcarbodiimid zu 11,0 g (58,0 mmol) Titantetrachlorid in 60 ml absolutem Dichlormethan gegeben. Bei der gleichen Temperatur tropft man eine Lösung von 2,90 g (8,20 mmol) 2-Brom-5-dodecylchinon in 32 ml Dichlormethan zu, läßt auf Raumtemperatur erwärmen und rührt noch weitere 48 h. Die Reaktionsmischung wird wie in Beispiel 10 aufgearbeitet. Das Produkt wird mit 200 ml Petrolether gefällt und die Fällung bei -25°C vervollständigt.
Ausbeute: 2,29 g (70 % d.Th.) (I.6) in Form eines orangefarbenen Niederschlags, Schmp.: 115°C.
Analyse $C_{20}H_{27}BrN_4$ (403)
Ber. C 59,55 H 6,75 N 13,89 %
Gef. C 60,07 H 7,21 N 13,67 %
Spektren:
IR (KBr): $\nu$ = 3030 $cm^{-1}$ (CH), 2915 (CH), 2842 (CH), 2165 (C≡N), 1555 (C=C), 1545 (C=N).
UV ($CH_3CN$): $\lambda_{max}$ (lg $\epsilon$) = 348 nm (4,47).

Beispiel 14

N,N′-Dicyan-2-hexyl-1,4-chinondiimin (I.7)

Analog Beispiel 9 werden 1,90 g (10,0 mmol) Titantetrachlorid in 15 ml absolutem Dichlormethan vorgelegt und bei 0°C 1,86 g (10,0 mmol) Bistrimethylsilylcarbodiimid innerhalb von 20 Minuten zugetropft. Zu der orangefarbenen Lösung werden 385 mg (2,00 mmol) 2-Hexyl-1,4-benzochinon in 5 ml Dichlormethan bei 0°C gegeben. Anschließend läßt man die Lösung erwärmen und rührt noch weitere 24 h bei Raumtemperatur. Aufarbeitung wie in Beispiel 9. Das Rohprodukt wird aus 8 ml Methylcyclohexan bei 75°C

umkristallisiert und 336 mg (70 % d.Th.) (I.7) als feiner gelber Niederschlag vom Schmp. 85 °C isoliert.
Analyse $C_{14}H_{16}N_4$ (240)
Ber. C 69,97 H 6,71 N 23,31 %
Gef. C 69,41 H 6,72 N 23,42 %
Spektren:
IR (KBr): $\nu$ = 3045 $cm^{-1}$ (CH), 2920 (CH), 2850 (CH), 2160 (C≡N), 1570 (C=C), 1545 (C=N).
UV ($CH_3CN$): $\lambda_{max}$ (lg $\epsilon$) = 334 nm (4,44).

Beispiel 15

N,N′-Dicyan-2-hexyl-5-methyl-1,4-chinodiimin (I.10)

Man arbeitet wie in Beispiel 9 und tropft bei 0 °C 11,4 g (61,2 mmol) Bistrimethylsilylcarbodiimid zu 12,0 g (63,0 mol) Titantetrachlorid in 60 ml absolutem Dichlormethan. Danach wird langsam eine Lösung von 2,50 g (12,1 mmol) 2-Hexyl-5-methyl-1,4-benzochinon zugegeben und anschließend 24 h bei Raumtemperatur gerührt. Man isoliert 2,51 g (82 % d.Th.) (I.10) in Form von analysenreinen orangenen Nadeln, die sich bei 98 °C zersetzen.
Analyse $C_{15}H_{18}N_4$ (254)
Ber. C 70,84 H 7,13 N 22,03 %
Gef. C 70,44 H 7,25 N 21,65 %
Spektren:
IR (KBr): $\nu$ = 3040 $cm^{-1}$ (CH), 2920 (CH), 2850 (CH), 2170 (C≡N), 1580 (C=C), 1540 (C=N).
UV ($CH_3CN$): $\lambda_{max}$ (lg $\epsilon$) = 346 nm (4,48).

Beispiel 16

N,N′-Dicyan-2-brom-5-hexyl-1,4-chinodiimin (I.8)

In Anlehnung an Beispiel 9 werden 5,50 g (29,0 mmol) Titantetrachlorid in 15 ml absolutem Dichlormethan vorgelegt und 5,31 g (28,5 mmol) Bistrimethylsilylcarbodiimid bei 0 °C langsam zugetropft. Anschließend tropft man 1,55 g (5,70 mol) 2-Brom-5-hexyl-1,4-benzochinon in 20 ml Dichlormethan zu, rührt weitere 24 h und arbeitet wie in Beispiel 9 auf. Man erhält 1,37 g (75 % d.Th.) (I.8) als analysenreinen orangenen Feststoff vom Schmp. 114 °C (Zers.).
Analyse $C_{14}H_{15}BrN_4$ (319)
Ber. C 52,68 H 4,74 N 17,55 %
Gef. C 52,83 H 4,70 N 17,36 %
Spektren:
IR (KBr): $\nu$ = 3030 $cm^{-1}$ (CH), 2915 (CH), 2840 (CH), 2162 (C≡N), 1555 (C=C), 1540 (C=N).
UV ($CH_3CN$): $\lambda_{max}$ (lg $\epsilon$) = 350 nm (4,49), 368 (4,36) sh.

Beispiel 17

N,N′-Dicyan-2,3-dipropyl-1,4-benzochinondiimin (I.9)

595 mg (= 3,10 mmol) 2,3-Dipropyl-1,4-benzochinon werden in 15 ml absolutem Dichlormethan gelöst und bei 0 °C mit 2,46 g (= 13,0 mmol) Titantetrachlorid und anschließend mit 3,16 g (= 17,0 mmol) Bistrimethylsilylcarbodiimid in 5 ml Dichlormethan versetzt. Nach 2 h Rühren bei Raumtemperatur (DC-Kontrolle) wird die Reaktionsmischung auf Eiswasser gegossen, dreimal mit je 30 ml Dichlormethan extrahiert und die vereinigten organischen Extrakte über $MgSO_4$ getrocknet.

Nach dem Entfernen des Lösungsmittels gibt man 50 ml Methylcyclohexan zu und beschallt 5 min im Ultraschallbad bei Raumtemperatur. Der unlösliche braune Rückstand wird abfiltriert und die Lösung auf -78 °C gekühlt.

Man isoliert 198 mg (27 % d.Th.) orangene Kristalle von (I.9), welche bei 77 °C schmelzen und sich ab 125 °C zersetzen.

Analyse $C_{14}H_{16}N_4$ (236)

Ber. C 69,97 H 6,71 N 23,32 %

Gef. C 70,26 H 6,76 N 22,93 %

Spektren:

IR (KBr): $\nu$ = 3060 $cm^{-1}$ (=C-H), 2970 (C-H), 2170 (C≡N), 1560 (C=C), 1540 (C=N).

UV ($CH_3CN$): $\lambda_{max}$ (lg $\epsilon$) = 332 nm (4,36), 343sh (4,33), 395sh (3,73).

Beispiel 18

N,N′-Dicyan-2,5-dipropyl-1,4-benzochinondiimin (I.11)

875 mg (= 4,55 mmol) 2,5-Dipropyl-1,4-benzochinon), gelöst in 20 ml absolutem Dichlormethan, werden mit 3,45 g (= 18,2 mmol) Titantetrachlorid und anschließend mit 3,39 g (= 18,2 mmol) Bistrimethylsilylcarbodiimid in 5 ml Dichlormethan bei Raumtemperatur versetzt. Nach 8 h (DC-Kontrolle) wird auf 200 ml Eiswasser gegossen, 3 mal mit je 100 ml Dichlormethan extrahiert, über Magnesiumsulfat getrocknet und nach teilweisem Entfernen des Lösungsmittels mit Petrolether gefällt. Man erhält nach dem Umkristallisieren aus Methylcyclohexan (50 ml auf 750 mg Rohprodukt) 730 mg (I.11) (= 67 % d.Th.) ockergelbe Kristalle, die sich bei 148 °C zersetzen.

Analyse $C_{14}H_{16}N_4$ (240)

Ber. C 69,97 H 6,71 N 23,32 %

Gef. C 70,02 H 6,86 N 23,43 %

Spektren:

IR (KBr): $\nu$ = 3030 $cm^{-1}$ (C-H), 2960 (C-H), 2175 (C≡N), 1580 (C=C), 1535 (C=N).

UV ($CH_3CN$): $\lambda_{max}$ (lg $\epsilon$) = 344 nm (4,44).

II. Charge-Transfer-Komplexe

Beispiel 19

Zu einer heißen Lösung von N,N′-Dicyano-2-isopropyl-5-methyl-p-benzochinonbisimin in Acetonitril gibt man die äquimolare Menge Tetrathiafulvalen in Form einer heißen Lösung in Acetonitril. Nach dem Absaugen, Waschen mit wenig Ether und Trocknen erhält man den Charge-Transfer-Komplex mit Donor-Akzeptor-Zusammensetzung = 1:1. Ausbeute: 41 % d.Th., Schmp. 104 °C

Leitfähigkeit $< 10^{-7}$ S • $cm^{-1}$ (Pulverpreßling)

Beispiel 20

Man verfährt analog Beispiel 19, verwendet jedoch 2 Mol des Bisimins und 3 Mol Tetrathiafulvalen. Man erhält einen Charge-Transfer-Komplex mit einer Zusammensetzung von 2 Donor : 3 Akzeptor. Ausbeute: 37 % d.Th. Schmp. 83 °C

Leitfähigkeit $1{,}0 \cdot 10^{-2}$ S•$cm^{-1}$ (Pulverpreßling).

Beispiel 21

Analog Beispiel 19 wurde N,N′-Dicyano-2-jod-5-methyl-p-benzochinondiimin mit Tetrathiafulvalen im Verhältnis 1:1 Mol in Methylenchlorid umgesetzt. Ausbeute: 75 % d.Th. eines 1:1-Komplexes.
Schmp. 144 °C
Leitfähigkeit: $3 \cdot 10^{-2}$ S $cm^{-1}$ (Pulverpreßling)

Beispiel 22 bis 24

Man verfährt wie in Beispiel 19, verwendet jedoch die in der folgenden Tabelle angegebenen N,N-Dicyano-p-benzochinondiimine, dann erhält man die entsprechenden Charge-Transfer-Komplexe.

| Beispiel | (I) $R^4$ = H<br>$R^1$ | $R^2$ | $R^3$ | Schmp. [°C] | Ausbeute [%] d.Th. | IR (KBr) [$cm^{-1}$] | DCNQI : TTF | Leitfähigkeit [$Scm^{-1}$] |
|---|---|---|---|---|---|---|---|---|
| 22 | J | H | H | 104 | 53 | 2100 | 1:1 | $3 \cdot 10^{-5}$ |
| 23 | J | H | Br | 127 | 55 | 2110 | 1:1 | 0,02 |
| 24 | J | H | J | 192 | 63 | 2080 | 1:1 | $6 \cdot 10^{-3}$ |

DCNQI = N,N'-Dicyano-p-benzochinoniminverbindung
TTF = Tetrathiafulvalen

Beispiel 25

N,N′-Dicyan-2,5-dipropyl-1,4-benzochinondiimin mit Tetrathiafulvalen

Zu einer Lösung von 72,0 mg (= 300 µmol) N,N′-Dicyan-2,5-dipropyl-1,4-benzochinondiimin in 5 ml Acetonitril gibt man eine Lösung von 61,0 mg (= 300 µmol) Tetrathiafulvalen in 3 ml Acetonitril. Aus der sich sofort grün färbenden Lösung kristallisieren beim Abkühlen auf -25 °C 90 mg (68 % d.Th.) moosgrüne Kristalle des Charge-Transfer-Komplex aus. Die Verbindung besteht aus N,N′-Dicyan-2,5-dipropyl-1,4-benzochinondiimin und Tetrathiafulvalen im Verhältnis 1:1 Mol und zersetzt sich ab 139 °C.
Analyse $C_{20}H_{20}N_4S_4$ (444)
Ber. C 54,02 H 4,53 N 12,60 %
Gef. C 54,08 H 4,56 N 12,96 %
Spektren:
IR (KBr): = 2155 $cm^{-1}$ (C≡N),
UV ($CH_3CN$): $\lambda_{max}$ (lg ε) = 362 sh (4,33), 343 (4,47), 324 nm (4,47).

Beispiel 26

Umsetzung von N,N′-Dicyan-2-brom-5-dodecyl-1,4-chinondiimin mit Tetrathiafulvalen

In einem ausgeheizten Schlenk-Rohr werden 110 mg (250 µmol) N,N′-Dicyan-2-brom-5-dodecyl-1,4-chinondiimin in 4 ml absolutem Dichlormethan gelöst und bei Raumtemperatur 50,0 mg (250 µmol) Tetrathiafulvalen in 2 ml absolutem Dichlormethan zugegeben. Die Lösung färbt sich sofort schwarz. Nach 5 min kühlt man zunächst langsam auf 0 °C, dann auf -20 °C und filtriert den schwarzen Feststoff nach 1,5

h rasch ab. Nach Trocknung über Kieselgel erhält man 124 mg (83 % d.Th.) des 1:1 Charge-Transfer-Komplexes in Form von schwarzen Nädelchen vom Schmp. 86 °C (Zers.), die sich bei Raumtemperatur langsam zersetzen.

Analyse $C_{26}H_{31}BrN_4S_4$ (608)

Ber. C 51,39 H 5,14 N 9,22 %

Gef. C 51,54 H 5,30 N 9,58 %

Spektren:

IR (KBr): 2110 $cm^{-1}$ (C≡N, breit)

UV ($CH_3CN$): $\lambda_{max}$ (lg $\epsilon$) = 348 nm (4,52), 363 (4,42) sh, 425 (3,60), 576 (3,23), 620 (3,38), 686 (3,41).

Beispiel 27

Umsetzung von N,N′-Dicyan-2-brom-5-hexyl-1,4-chinondiimin mit Tetrathiafulvalen

Zu 96,0 mg (300 µmol) N,N′-Dicyan-2-brom-5-hexyl-1,4-chinondiimin in 2 ml absolutem Dichlormethan wird bei Raumtemperatur eine Lösung von 61,0 mg (300 µmol) Tetrathiafulvalen in 2 ml Dichlormethan gegeben. Es fällt sofort ein schwarzer Feststoff aus. Man kühlt nach 5 min auf 0 °C, filtriert den sehr feinen Niederschlag ab und wäscht tropfenweise mit Ether. Nach den Trocknung über Kieselgel erhält man 92 mg (59 % d.Th.) des 1:1-Charge-Transfer-Komplexes von Schmp. 87 °C (Zers.).

Analyse $C_{20}H_{19}BrN_4S_4$ (524)

Ber. C 45,88 H 3,66 N 10,70 %

Gef. C 45,64 H 3,69 N 10,44 %

Spektren:

IR (KBr): 2120 $cm^{-1}$ (C≡N, breit).

UV ($CH_3CN$): $\lambda_{max}$ (lg $\epsilon$) = 324 nm (4,37) sh, 349 (4,48), 364 (4,35) sh, 428 (3,61), 577 (3,23), 618 (3,34), 686 (3,35).

III. Radikalionensalze

Beispiel 28

162 mg (0,5 mmol) Biscyanimin aus Beispiel 1 werden in Acetonitril gelöst und bei 55 °C mit 133 mg (0,7 mmol) Kupfer-I-jodid versetzt. Dabei fällt ein dunkler Niederschlag aus, der abgesaugt und mit Acetonitril gewaschen wird. Das Salz enthält kein Halogen (Beilsteinprobe negativ). Schmp. 96 °C (Zers.). IR (KBr): 2147 $cm^{-1}$ (C≡N)

Beispiel 29

Man verfährt wie in Beispiel 28, verwendet jedoch ein Verhältnis von 3 Mol N,N′-Dicyano-2-isopropyl-5-methyl-p-benzochinondiimin und 2 Mol Kupfer-I-jodid.

Ausbeute: 25 % d.Th. Radikalionensalz der Formel

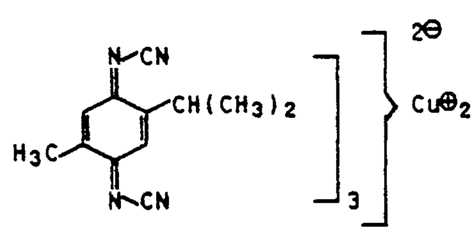

Schmp. 109 °C
Leitfähigkeit: $7 \cdot 10^{-2}$ $S \cdot cm^{-1}$ (Pulverpreßling)

Beispiel 30

Man verfährt wie in Beispiel 28, verwendet jedoch N,N′-Dicyano-2-jod-5-methyl-p-benzochinondiimin und Kupfer-I-jodid im Molverhältnis 2:1. Ausbeute an 88 % d.Th. an Radikalionensalz der Formel

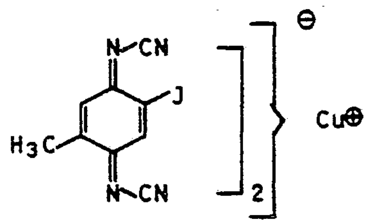

Schmp. 190 °C
Leitfähigkeit: 200 S $cm^{-1}$ (Einkristall)

Beispiel 31

Herstellung des Radikalionensalzes durch Elektrolyse

Die Elektrolyse erfolgte in einer 60 ml Flüssigkeit fassenden, durch zwei G4-Glasfritten in 3 Kammern geteilten Zelle. Jede Kammer kann unabhängig von den anderen unter Schutzgas gefüllt bzw. entleert werden.

Die Elektroden befinden sich in den äußeren Kammern. Durch die Dreiteilung wird verhindert, daß an der Anode gebildete Nebenprodukte in den Kathodenraum eindringen können.

Als Elektroden dienen zwei Platinbleche von 20 x 10 x 1 mm. Elektroden und Zelle wurden vor jeder Verwendung mit einer Mischung aus 35 % Wasserstoffsuperoxid und konz. Schwefelsäure gereinigt. Anschließend wurde mit Wasser gespült und dann die Zelle 1 Tag in destilliertem Wasser gewässert, um letzte Spuren Säure zu entfernen. Dann wurde die Zelle bei 120 °C getrocknet.

Die Stromversorgung erfolgte mit einer Konstantstromquelle, deren Strom zwischen 0 und 250 µA geregelt werden kann.

Durch Einstellen der Zelle in ein temperierbares Bad kann die Elektrolyse bei definierten Temperaturen durchgeführt werden.

Zur Elektrolyse wird in alle drei Kammern der Zelle eine Lösung von N,N′-Dicyano-2-methyl-5-isopropyl-1,4-benzochinondiimin (3 Mol) und Silbernitrat (2 Mol) in 60 ml Acetonitril gegeben und bei Raumtemperatur mit einer Stromstärke von 3 µA elektrolysiert. An der Kathode wachsen bis zu 3 cm lange, dünne Kristallnadeln. Nach 80 h isoliert man das Silbersalz der Formel

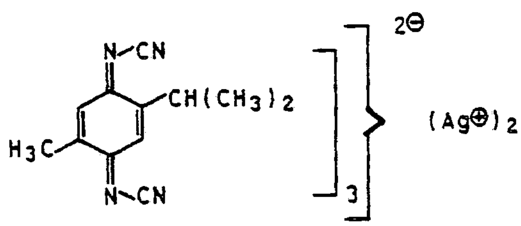

Schmp.: 150 °C (Zers.)
Leitfähigkeit: $4 \cdot 10^{-2}$ $S \cdot cm^{-1}$ (Pulverpreßling)

Die Lösungen wurden dabei nicht bis zum Ende elektrolysiert um Überreduktion zu vermeiden.

Beispiel 32

Man verfährt wie in Beispiel 31, verwendet jedoch N,N′-Dicyano-2-jod-5-methyl-p-benzochinon-bisimin und Silbernitrat im Molverhältnis 2:1. Ausbeute: 32 %, Radikalionensalz der Formel

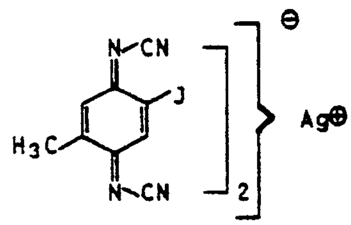

Beispiel 33

Umsetzung von N,N′-Dicyan-2,5-dipropyl-1,4-benzochinondiimin mit Kupfer-I-iodid

Man gibt zu einer siedenden Lösung von 72 mg (= 300 µmol) N,N′-Dicyan-2,5-dipropyl-1,4-benzochinondiimin in 5 ml Acetonitril eine Lösung von 95 mg (= 500 µmol) CuI in 3 ml Acetonitril. Dabei fällt sofort ein schwarzblauer Niederschlag aus. Man läßt erkalten und filtriert ab. Die Ausbeute an Radikalanionensalz beträgt 36 mg (43 % d.Th.). Die Verbindung besitzt die Zusammensetzung 3:2 (Akzeptor/Kupfer) und zersetzt sich ab 155 °C.

Analyse $C_{42}H_{48}Cu_2N_{12}$ (848)

Ber. C 59,49 H 5,70 N 19,82 %

Gef. C 59,91 H 5,97 N 19,28 %

IR (KBr): 2115 $cm^{-1}$ (C≡N).

Beispiel 34

Umsetzung von 2,5-Diallyl-N,N′-Dicyan-1,4-benzochinondiimin (2,5-DA-DCNQI) mit Kupfer-(I)-iodid

Zu einer Lösung von 71,0 mg (300 µmol) 2,5-Diallyl-N,N′-dicyan-1,4-benzochinondiimin in 5 ml Acetonitril wird bei Raumtemperatur eine Lösung von 95,0 mg (500 µmol) in 3 ml Acetonitril getropft. Sofort bildet sich ein bräunlicher Niederschlag. Man läßt 12 h bei -25 °C stehen, filtriert den mittlerweile grünen, feinpulvrigen Niederschlag ab und trocknet über Kieselgel. Ausbeute: 78 mg (75 % d.Th.) eines grünen Pulvers, das bei 237 °C unter Energieaufnahme schmilzt. Die Beilsteinprobe ist positiv. Das isolierte Produkt hat die Zusammensetzung: $(2,5\text{-DA-DCNQI})_4 \bullet Cu_5I$.

Analyse: $[C_{14}H_{12}N_4]_4 \bullet Cu_5 \bullet I$

Ber. C 48,40 H 3,48 N 16,13 I 9,13 %

Gef. C 48,10 H 3,50 N 16,06 I 9,20 %

IR (KBr): 3010 $cm^{-1}$ (C-H), 2890 (C-H), 2180 (C≡N), 1490 (C=N).

Beispiel 35

Umsetzung von N,N′-Dicyan-2-octadecyl-1,4-chinondiimin (I.2) mit Kupfer-I-iodid

204 mg (0,50 mmol) N,N′-Dicyan-2-octadecyl-1,4-chinondiimin werden in einer Mischung aus 30 ml Acetonitril und 12 ml Dichlormethan gelöst und eine entgaste Lösung von 133 mg (700 µmol) Kupfer-I-iodid in 7 ml Acetonitril zugegeben. Es entsteht sofort eine Blaufärbung und ein dunkler grünlicher Niederschlag scheidet sich ab. Nach 10 min Rühren bei 75° C wird die Lösung ins Ultraschallbad gehalten, worauf die Mischung eine homogene blauschwarze Färbung annimmt. Man läßt langsam auf Raumtemperatur abkühlen, filtriert und wäscht den Niederschlag mit 2 ml Acetonitril. Nach Trocknung über Kieselgel erhält man 235 mg (99 % d.Th.) (I.2)•Cu(1:1) als amorphen Feststoff von Schmp. 101° C (Zers.).

Analyse $C_{26}H_{40}N_4CU$ (472)
Ber. C 66,14 H 8,54 N 11,87 %
Gef. C 65,87 H 8,38 N 11,65 %
IR (KBr): $\nu$ = 2920 $cm^{-1}$ (CH), 2850 (CH), 2155 (C≡N).

Beispiel 36

Umsetzung von 2-Brom-N,N′-dicyan-5-octadecyl-1,4-chinondiimin (I.3) mit Kupfer-I-iodid

Man löst 244 mg (500 µmol) 2-Brom-N,N′-dicyan-5-octadecyl-1,4-chinondiimin (I.3) in 40 ml siedendem, absolutem Acetonitril und gibt eine entgaste Lösung von 133 mg (700 µmol) Kupfer-I-iodid in 8 ml absolutem Acetonitril zu. Die Reaktionsmischung färbt sich sofort dunkel und wird trüb. Man rührt 10 min in der Siedehitze und läßt langsam erkalten. Nach 1 h kühlt man auf 0° C, filtriert den Feststoff ab und wäscht mit kaltem Acetonitril bis die ablaufende Waschflüssigkeit blaugrün wird. Nach Trocknung über Kieselgel erhält man 263 mg (95 % d.Th.) (I.3)-Cu(5:4) vom Schmp. 132° C (Zers.) als amorphe schwarzblaue Festsubstanz.

Analyse $C_{133}H_{195}Br_5Cu_4N_{20}$ (2692)
Ber. C 58,01 H 7,30 N 10,41 %
Gef. C 58,39 H 7,45 N 10,33 %
IR (KBr): $\nu$ = 2910 $cm^{-1}$ (CH), 2840 (CH), 2150 (C≡N).

Beispiel 37

Umsetzung von N,N′-Dicyan-2-dodecyl-1,4-chinondiimin (I.4) mit Kupfer-I-iodid

162 mg (500 µmol) N,N′-Dicyan-2-dodecyl-1,4-chinondiimin (I.4) werden in 15 ml heißen Acetonitril gelöst und mit einer Lösung von 133 mg (0,70 mmol) Kupfer-I-iodid in 7 ml Acetonitril versetzt. Es scheidet sich sofort ein blauschwarzer Niederschlag ab. Nach 10 min Rühren bei 60° C, läßt man langsam abkühlen und filtriert den Feststoff ab, der mit 3 ml Acetonitril gewaschen wird. Man erhält 115 mg (I.4)-CU(1:1) (59 % d.Th.) in Form eines violett-schwarzen amorphen Niederschlags vom Schmp. 96° C (Zers.).

Analyse $C_{20}H_{28}CuN_4$ (388)
Ber. C 61,91 H 7,27 N 14,44 %
Gef. C 61,92 H 7,53 N 14,49 %
IR (KBr): $\nu$ = 2920 $cm^{-1}$ (CH), 2850 (CH), 2155 (C≡N).

Beispiel 38

Umsetzung von 2-Brom-N,N′-dicyan-5-dodecyl-1,4-chinondiimin (I.6) mit Kupfer-I-iodid

202 mg (500 µmol) 2-Brom-N,N′-dicyan-5-dodecyl-1,4-chinondiimin (I.6) werden bei Raumtemperatur in 10 ml eines 1:1-Gemisches aus Acetonitril und Dichlormethan gelöst und auf 75° C erwärmt. Anschließend wird eine entgaste Lösung von 133 mg (700 µmol) Kupfer-I-iodid in Acetonitril zugegeben, worauf sofort ein dunkler Niederschlag ausfällt. Nach 5 min läßt man langsam auf Raumtemperatur abkühlen und kühlt nach 30 min auf 0° C. Man filtriert, wäscht mit 2 ml Dichlormethan/Acetonitril und erhält 200 mg (86 % d.Th.) (I.6)-Cu(1:1) als amorphen Niederschlag vom Schmp. 125° C (Zers.).
Analyse $C_{20}H_{27}BrCuN_4$ (467)
Ber. C 51,45 H 5,83 N 12,00 %
Gef. C 51,47 H 6,12 N 12,28 %
IR (KBr): $\nu$ = 2915 $cm^{-1}$ (CH), 2845 (CH), 2158 (C≡N).

Beispiel 39

Umsetzung von N,N′-Dicyan-2-hexyl-1,4-chinondiimin (I.7) mit Kupfer-I-iodid

Man löst 120 mg (500 µmol) N,N′-Dicyan-2-hexyl-1,4-chinondiimin (I.7) in 10 ml Acetonitril und gibt bei 55° C eine entgaste Lösung von 133 mg (700 µmol) Kupfer-I-iodid in 5 ml Acetonitril zu. Es fällt sofort ein dunkler Niederschlag aus. Die Lösung wird nach 10 Minuten langsam auf 0° C gekühlt, der blauschwarze Niederschlag abfiltriert und mit 1 ml Acetonitril gewaschen. Man erhält 73 mg (49 %) (I.7)-Cu(1:1) als amorphen Niederschlag von Schmp. 88° C (Zers.).
Analyse $C_{14}H_{16}CuN_4$ (304)
Ber. C 55,34 H 5,31 N 18,44 %
Gef. C 54,30 H 5,35 N 18,26 %
IR (KBr): $\nu$ = 2918 $cm^{-1}$ (CH), 2850 (CH), 2140 (C≡N).

Beispiel 40

Umsetzung von N,N′-Dicyan-2-hexyl-5-methyl-1,4-chinondiimin (I.10) mit Kupfer-I-iodid

127 mg (500 µmol) N,N′-Dicyan-2-hexyl-5-methyl-1,4-chinondiimin (I.10) werden in 10 ml Acetonitril gelöst und in der Siedehitze mit 285 mg (1,50 mmol) Kupfer-I-iodid in 16 ml Acetonitril versetzt. Nach 30 min läßt man die Lösung erkalten, kühlt nach 2 h auf -25° C und filtriert den dunklen Niederschlag ab, der mit 2 ml Acetonitril und 3 ml Ether gewaschen wird bis die Waschflüssigkeit farblos ist. Man isoliert 72,0 mg (45 % d.Th.) (I.10)-CU(1:1) vom Schmp. 74° C (Zers.).
Analyse $C_{15}H_{18}N_4Cu$ (318)
Ber. C 56,68 H 5,71 N 17,63 %
Gef. C 56,40 H 5,83 N 17,27 %
IR (KBr): $\nu$ = 2920 $cm^{-1}$ (CH), 2850 (CH), 2150 (C≡N).

Beispiel 41

Umsetzung von 2-Brom-N,N′-dicyan-5-hexyl-1,4-chinondiimin (I.8) mit Kupfer-I-iodid

Man löst 160 mg (500 µmol) 2-Brom-N,N′-dicyan-5-hexyl-1,4-chinondiimin (I.8) in 30 ml absolutem Acetonitril und tropft bei 50° C eine Lösung von 133 mg (700 µmol) Kupfer-I-iodid in 10 ml absolutem Acetonitril zu. Nach 5 min läßt man die Lösung erkalten und kühlt nach weiteren 90 min zunächst auf 0° C, dann auf -25° C. Der Feststoff wird abfiltriert, mit Acetonitril gewaschen bis die Waschflüssigkeit blau wird

und getrocknet. Man isoliert 165 mg (86 % d.Th.) (I.8)-Cu(1:1) als rotvioletten amorphen Feststoff vom Schmp. 87° C (Zers.).
Analyse $C_{14}H_{15}BrCuN_4$ (383)
Ber. C 43,93 H 3,95 N 14,64 %
Gef. C 44,15 H 4,12 N 14,92 %
IR (KBr): $\nu$ = 2910 $cm^{-1}$ (CH), 2840 (CH), 2150 (C≡N).

Beispiele 42 bis 44

Es wurde wie in Beispiel 41 verfahren, jedoch wurden die in der Tabelle angegebenen N,N′-Dicyano-1,4-chinondiimine der Formel verwendet

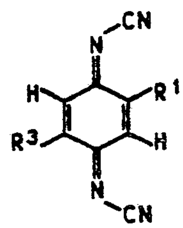

Die isolierten Radikalionensalze sind jodfrei (Beilsteinprobe: negativ)

| Beispiel | $R^1$ | $R^3$ | Schmp. [°C] | Ausbeute [%] d.Th. | IR (KBr) [$cm^{-1}$] | Zusammensetzung DCNQI:Cu | Leitfähigkeit [$Scm^{-1}$] |
|---|---|---|---|---|---|---|---|
| 42 | I | H | 79 | 23 | 2160 | 1:1 | 0,1 |
| 43 | I | Br | 175 | 37 | -a) | 2:1 | 0,01 |
| 44 | I | I | 164 | 46 | -a) | 2:1 | 0.02 |

DCNQI = N,N-Dicyano-1,4-benzochinoniminverbindung
a) keine Banden bei starker Absorption

Beispiel 45

Es wurde wie in Beispiel 22 verfahren, jedoch wurde N,N′-Dicyano-2-jod-5-brom-1,4-benzochinondiimin und Silbernitrat verwendet.
Es wurde das Radikaliminsalz

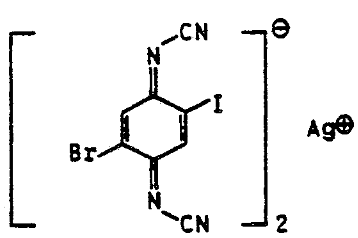

vom Schmp. 164° C erhalten.
IR (KBr) 2170 $cm^{-1}$.

Beispiel 46

Elektrolyse von N,N′-Dicyan-2-iod-5-methyl-1,4-benzochinondiimin (I.12) mit Kupfer(II)bromid

Eine Lösung von 88,8 mg (300 µmol) N,N′-Dicyan-2-iod-5-methyl-1,4-benzochinondiimin (I.12) und 44.7 (200 µmol) Kupfer(II)bromid in 60 ml Acetonitril wird mit einem konstanten Strom von 30 µA elektrolysiert (Pt-Draht-Kathode, ⌀ 1 mm, Stromdichte 187,5 $\mu Acm^{-2}$). Nach 49 h werden die an der Kathode abgeschiedenen, bis zu 10 mm langen, schwarzen, metallisch glänzenden Nadeln abgesaugt, mit Acetonitril gewaschen und über Kieselgel getrocknet. Die Verbindung besteht aus N,N′-Dicyan-2-iod-5-methyl-1,4-benzochinondiimin und Kupfer im Verhältnis 2:1. Schmp. 190 °C (Zers.). Die Ausbeute beträgt 13,0 mg (= 13 % d.Th.).

Analyse $C_{18}H_{10}CuI_2N_8$ (656)

Ber. C 32,97 H 1,54 N 17,09 %

Gef. C 33,66 H 1,41 N 17,12 %

IR (KBr): Die Verbindung zeigt im IR-Spektrum keine Baden bei hoher Absorption.

Beispiel 47

Elektrolyse von N,N′-Dicyan-2-iod-5-methyl-1,4-benzochinondiimin und N,N′-Dicyan-2,5-dimethyl-1,4-benzochinondiimin mit Kupfer(II)bromid

Eine Lösung von 59,2 mg (200 µmol) N,N′-Dicyan-2-iod-5-methyl-1,4-benzochinondiimin. 37,8 mg (200 µmol) N,N′-Dicyan-2,5-dimethyl-1,4-benzochinondiimin und 66,9 mg (300 µmol) Kupfer(II)bromid in 60 ml Acetonitril wird mit einem konstanten Strom von 50 µA elektrolysiert. Nach 93 h werden die an der Kathode abgeschiedenen, bis zu 10 mm langen, schwarzen, metallisch glänzenden Nadeln abgesaugt, mit Acetonitril gewaschen und über Kieselgel getrocknet. Die Verbindung besteht aus N,N′-Dicyan-2,5-dimethyl-1,4-benzochinondiimin, N,N′-Dicyan-2-iod-5-methyl-1,4-benzochinondiimin und Kupfer im Verhältnis 2:4:3 Schmp. 177 °C (Zers.). Die Ausbeute beträgt 25,3 mg (= 33 % d.Th.) Leitfähigkeit: 200 $Scm^{-1}$.

Analyse $C_{56}H_{36}Cu_3I_4N_{24}$ (1743)

Ber. C 38,58 N 2,08 N 19,28 %

Gef. C 38,19 H 1,96 N 18,86 %

IR (KBr): Die Verbindung zeigt im IR-Spektrum keine Banden bei hoher Absorption.

Beispiel 48

Elektrolyse von N,N′-Dicyan-2-iod-5-methyl-1,4-benzochinondiimin mit Lithiumperchlorat

Man elektrolysiert bei -25 °C eine Lösung von 59,2 mg (200 µmol) N,N′-Dicyan-2-iod-5-methyl-1,4-benzochinondiimin und 106 mg (1,00 µmol) Lithiumperchlorat in 60 ml Acetonitril 193 h bei einer Stromstärke von 10 µA (Pt-Blech-Kathode), 2,8 $cm^2$, Stromdichte 3,6 $\mu Acm^{-2}$). Dabei scheiden sich an der Kathode schwarze, metallisch glänzende Kristalle ab. Diese werden isoliert, mit Ether gewaschen und über Kieselgel getrocknet. Das Produkt besteht aus N,N′-Dicyan-2-iod-5-methyl-1,4-benzochinondiimin und Lithium im Verhältnis 2:1. Die Ausbeute beträgt 19,0 mg (32 % d.Th.), Schmp. 156 °C (Zers.). Leitfähigkeit: 7 x $10^{-2}$ $Scm^{-1}$.

Analyse $C_{18}H_{10}I_2LiN_8$ (599)

Ber. C 36,09 H 1,68 N 18,70 %

Gef. C 36,45 H 1,68 N 19,01 %

IR (KBr): 2150 $cm^{-1}$ (C≡N).

Beispiel 49

Elektrolyse von N,N'-Dicyan-2-iod-5-methyl-1,4-benzochinondiimin mit Natriumperchlorat

Man elektrolysiert bei -25 °C eine Lösung von 59,2 mg (200 µmol) N,N'-Dicyan-2-iod-5-methyl-1,4-benzochinondiimin und 123 mg (1,00 µmol) Natriumperchlorat in 60 ml Acetonitril 276 h bei einer Stromstärke von 5 µA. Dabei scheiden sich an der Kathode schwarze, metallisch glänzende Kristalle ab. Diese werden isoliert, mit Ether gewaschen und über Kieselgel getrocknet. Das Produkt besteht aus N,N'-Dicyan-2-iod-5-methyl-1,4-benzochinondiimin und Natrium im Verhältnis 2:1. Die Ausbeute beträgt 18,2 mg (= 29 % d.Th.). Schmp. 137 °C (Zers.), Leitfähigkeit: 0,1 $Scm^{-1}$.
Analyse $C_{18}H_{10}I_2NaN_8$
Ber. C 35,15 H 1,64 N 18,22 %
Gef. C 35,17 H 1,71 N 18,18 %
IR (KBr): 2150 $cm^{-1}$ (C≡N).

Beispiel 50

Elektrolyse von N,N'-Dicyan-2-iod-5-methyl-1,4-benzochinondiimin mit Kaliumperchlorat

Man elektrolysiert bei -25 °C eine Lösung von 59,2 mg (200 µmol) N,N'-Dicyan-2-iod-5-methyl-1,4-benzochinondiimin und 139 mg (1,00 µmol) Kaliumperchlorat in 60 ml Acetonitril 276 h bei einer Stromstärke von 5 µA. Dabei scheiden sich an der Kathode schwarze, metallisch glänzende Kristalle ab, die man isoliert, mit Ether wäscht und über Kieselgel trocknet. Das Produkt besteht aus N,N'-Dicyan-2-iod-5-methyl-1,4-benzochinondiimin und Kalium im Verhältnis 2:1. Die Ausbeute beträgt 24,1 mg (= 38 % d.Th.). Schmp. 131 °C (Zers.). Leitfähigkeit: $7x10^{-2}$ $Scm^{-1}$.
Analyse $C_{18}H_{10}I_2KN_8$
Ber. C 34,25 H 1,60 N 17,75 %
Gef. C 34,81 H 1,57 N 18,14 %
IR (KBr): 2150 $cm^{-1}$ (C≡N).

Beispiel 51

Elektrolyse von N,N'-Dicyan-2,5-dimethyl-1,4-benzochinondiimin mit Thalliumnitrat

Man elektrolysiert bei -25 °C eine Lösung von 36,9 mg (200 µmol) N,N'-Dicyan-2,5-dimethyl-1,4-benzochinondiimin und 26,5 mg (100 µmol) Thalliumnitrat in 55 ml Acetonitril und 5 ml Dimethylsulfoxid 26 h bei einer Stromstärke von 20 µA. Dabei scheiden sich an der Kathode schwarze, metallisch glänzende Kristalle ab, die man isoliert, mit Ether wäscht und über Kieselgel trocknet. Das Produkt besteht aus N,N'-Dicyan-2,5-dimethyl-1,4-benzochinondiimin und Thallium im Verhältnis 2:1. Die Ausbeute beträgt 24 % d.Th.; Schmp. 161 °C (Zers.), Leitfähigkeit: 0,12 $Scm^{-1}$.
Analyse $C_{20}H_16N_8Tl$
Ber. C 41,93 H 2,82 N 19,57 %
Gef. C 41,84 H 2,87 N 19,64 %
IR (KBr): 2120 $cm^{-1}$, 2080 (C≡N).

## Ansprüche

1. Biscyanimin der allgemeinen Formel I

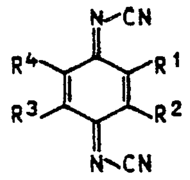

(I),

in der
$R^1$ für 1- oder 2-Propyl, für $C_5$- bis $C_{20}$-Alkyl, $C_3$- bis $C_{20}$-Alkenyl oder Jod und
$R^2$, $R^3$ und $R^4$ unabhängig voneinander für Wasserstoff, Chlor, Brom, Jod, Fluor, Phenyl, $C_1$- bis $C_{20}$-Alkyl, $C_3$- bis $C_{20}$-Alkenyl oder $C_1$- bis $C_8$-Alkoxy stehen.

2. Biscyanimin gemäß Anspruch 1, dadurch gekennzeichnet, daß in der Formel $R^2$ und $R^4$, oder $R^3$ und $R^4$ oder $R^2$, $R^3$ und $R^4$ für Wasserstoff stehen.

3. Biscyanimin gemäß Anspruch 1, dadurch gekennzeichnet, daß in der Formel $R^2$ und $R^4$ für Wasserstoff stehen.

4. Biscyanimin gemäß Anspruch 1, dadurch gekennzeichnet, daß in der Formel $R^1$ für Jod steht.

5. Biscyanimin gemäß Anspruch 2, dadurch gekennzeichnet, daß in der Formel $R^1$ für Jod steht.

6. Biscyanimin gemäß Anspruch 3, dadurch gekennzeichnet, daß in der Formel $R^1$ für Jod steht.

7. Charge-Transfer-Komplex aus einem Biscyanimin der allgemeinen Formel

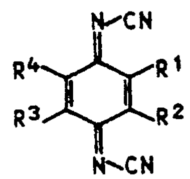

(I),

und einer Fulvalenverbindung der allgemeinen Formel

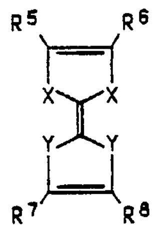

(II),

wobei das Verhältnis von (I) : (II) = 1:1, 2:1, 3:2, 1:2 oder 2:3 Mol beträgt und in den Formeln
$R^1$ für 1- oder 2-Propyl, für $C_5$- bis $C_{20}$-Alkyl, $C_3$- bis $C_{20}$-Alkenyl oder Jod und
$R^2$, $R^3$ und $R^4$ unabhängig voneinander für Wasserstoff, Chlor, Brom, Jod, Fluor, Phenyl, $C_1$- bis $C_{20}$-Alkyl, $C_3$- bis $C_{20}$-Alkenyl oder $C_1$- bis $C_8$-Alkoxy,
$R^5$, $R^6$, $R^7$ und $R^8$ unabhängig voneinander für Wasserstoff, Methyl oder Ethyl, oder $R^5$ und $R^6$ oder $R^7$ und $R^8$ oder $R^5$ und $R^6$ und $R^7$ und $R^8$ zusammen jeweils für einen Rest der Formel

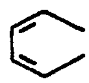 , 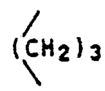 , 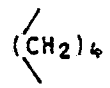 , 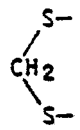 , 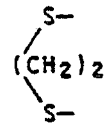 oder

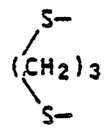 und

X und Y unabhängig voneinander für S oder Se stehen.

8. Charge-Transfer-Komplex gemäß Anspruch 7, dadurch gekennzeichnet, daß X und Y gleich sind.

9. Charge-Transfer-Komplex gemäß Anspruch 7, dadurch gekennzeichnet, daß $R^5$, $R^6$, $R^7$ und $R^8$ Wasserstoff sind.

10. Charge-Transfer-Komplex gemäß Anspruch 8, dadurch gekennzeichnet, daß $R^5$, $R^6$, $R^7$ und $R^8$ Wasserstoff sind.

11. Charge-Transfer-Komplex gemäß Anspruch 7, dadurch gekennzeichnet, daß $R^2$ und $R^4$ Wasserstoff sind.

12. Charge-Transfer-Komplex gemäß Anspruch 8, dadurch gekennzeichnet, daß $R^2$ und $R^4$ Wasserstoff sind.

13. Charge-Transfer-Komplex gemäß Anspruch 10, dadurch gekennzeichnet, daß $R^2$ und $R^4$ Wasserstoff sind.

14. Radikalionensalz der allgemeinen Formel

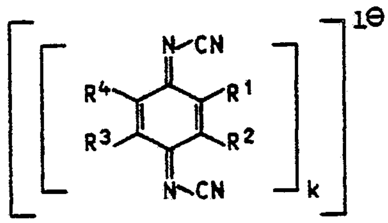 $[M^{m\oplus}]_n$ $I^{\ominus}_z$ (III),

in der

$R^1$ für 1- oder 2-Propyl, für $C_5$- bis $C_{20}$-Alkyl, $C_3$- bis $C_{20}$-Alkenyl oder Jod und

$R^2$, $R^3$ und $R^4$ unabhängig voneinander für Wasserstoff, Chlor, Brom, Jod, Fluor, Phenyl, $C_1$- bis $C_{20}$-Alkyl, $C_3$- bis $C_{20}$-Alkenyl oder $C_1$- bis $C_8$-Alkoxy,

$M^{m\oplus}$ für ein m-wertiges Alkalimetall-, Erdalkalimetall-, Übergangsmetall-, Ammonium- oder Phosphoniumion,

k für 1 bis 3,

l für 1 bis 3,

m für 1 oder 2,

n für 1 bis 3 und

z für 0 bis 2 stehen, wobei k, l, n und zu auch gebrochene Zahlen sein können und die Summe $(l+z)$ = $n \bullet m$ ist.

15. Radikalionensalz gemäß Anspruch 14, dadurch gekennzeichnet, daß $R^2$ und $R^4$ Wasserstoff sind.

16. Radikalionensalz gemäß Anspruch 14, dadurch gekennzeichnet, daß $M^{m\oplus}$ für ein Lithium-, Natrium-, Kalium-, Rubidium-, Caesium-, Thallium-, Kupfer-I- oder Silberion, oder für Tetramethylammonium, Tetraethylammonium, Tetrabenzylammonium, Trimethylbenzylammonium, Triethylbenzylammonium, Chinolinium, Pyridinium, N-Methylpyridinium, N-Methylchinolinium oder N-Ethylchinolinium steht.

17. Radikalionensalz gemäß Anspruch 15, dadurch gekennzeichnet, daß $M^{m\oplus}$ für ein Lithium-, Natrium-, Kalium-, Rubidium-, Caesium-, Thallium-, kupfer-I- oder Silberion, oder für Tetramethylammonium, Tetraethylammonium, Tetrabenzylammonium, Trimethylbenzylammonium, Triethylbenzylammonium, Chinolinium, Pyridinium, N-Methylpyridinium, N-Methylchinolinium oder N-Ethylchinolinium steht.

18. Radikalionensalz gemäß Anspruch 14, dadurch gekennzeichnet, daß z = 0 ist.

19. Radikalionensalz gemäß Anspruch 15, dadurch gekennzeichnet, daß z = 0 ist.

20. Radikalionensalz gemäß Anspruch 17, dadurch gekennzeichnet, daß z = 0 ist.

21. Radikalionensalz gemäß Anspruch 14, dadurch gekennzeichnet, daß $M^{m\oplus}$ $Cu^{\oplus}$ oder $Ag^{\oplus}$ ist.

22. Radikalionensalz gemäß Anspruch 15, dadurch gekennzeichnet, daß $M^{m\oplus}$ $Cu^{\oplus}$ oder $Ag^{\oplus}$ ist.

Europäisches Patentamt

# EUROPÄISCHER RECHERCHENBERICHT

Nummer der Anmeldung

EP 88 10 8366

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| P,A | ANGEWANDTE CHEMIE, Band 100, Nr. 2, 1988, Seiten 286-287; P. ERK et al.: "Das Kupfersalz von 2-Iod-5-methyl-N,N'-dicyanchinondiimin - ein Radikalanionensalz mit metallischer Leitfähigkeit bis zu tiefsten Temperaturen" --- | 1 | C 07 C 125/08<br>H 01 L 29/28<br>C 07 D 339/06<br>C 07 D 343/00<br>C 07 D 345/00 |
| D,A | EP-A-0 206 266 (BASF AG) * Anspruch 1 * --- | 14 | |
| D,A | DE-A-3 437 814 (BASF AG) * Ansprüche 1,3 * --- | 7,1 | |
| P,A | LIEBIGS ANNALYTISCHE CHEMIE, 1987, Seiten 997-1006; A. AUMÜLLER et al.: "N,N'-Dicyanchinondiimine/Tetrathiafulvalen-Addukte - Eine neue Klasse elektrisch leitfähiger CT-Komplexe" * Seite 998, Tabelle 1, Verbindungen j,k,p * --- | 7,1 | **RECHERCHIERTE SACHGEBIETE (Int. Cl.4)** |
| P,A | MOLECULAR CRYSTALS AND LIQUID CRYSTALS, Band 156, Teil A, 1988, Seiten 215-221; A. AUMÜLLER et al.: "A new class of compounds with high electrical conductivity" ----- | 7,1 | C 07 C 125/08<br>C 07 D 339/06<br>C 07 D 343/00<br>C 07 D 345/00 |

Der vorliegende Recherchenbericht wurde für alle Patentansprüche erstellt

| Recherchenort | Abschlußdatum der Recherche | Prüfer |
|---|---|---|
| BERLIN | 31-08-1988 | KAPTEYN H G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
& : Mitglied der gleichen Patentfamilie, übereinstimmendes Dokument